(19) Europäisches Patentamt
European Patent Office
Office européen des brevets

(11) Veröffentlichungsnummer: **0 259 754 A2**

(12) # EUROPÄISCHE PATENTANMELDUNG

(21) Anmeldenummer: **87112720.5**

(51) Int. Cl.⁴: **H05K 3/10**

(22) Anmeldetag: **01.09.87**

(30) Priorität: **12.09.86 DE 3631011**

(43) Veröffentlichungstag der Anmeldung:
**16.03.88 Patentblatt 88/11**

(84) Benannte Vertragsstaaten:
**BE CH DE FR GB IT LI NL SE**

(71) Anmelder: **BAYER AG**

**D-5090 Leverkusen-Bayerwerk(DE)**

(72) Erfinder: **Wolf, Gerhard Dieter, Dr.**
**Wilhelm-Busch-Strasse 29**
**D-4047 Dormagen 5(DE)**
Erfinder: **Sirinyan, Kirkor, Dr.**
**Humperdinckstrasse 12**
**D-5060 Bergisch Gladbach 2(DE)**
Erfinder: **Von Gizycki, Ulrich, Dr.**
**Wiembachallee 24**
**D-5090 Leverkusen 3(DE)**
Erfinder: **Merten, Rudolf, Dr.**
**Berta-von-Suttner-Strasse 55**
**D-5090 Leverkusen 1(DE)**

(54) **Flexible Schaltungen.**

(57) Flexible Schaltungen erhält man auf elegante Weise ohne die üblichen Ätzmethoden naßchemisch nach den Prinzipien der Semi-oder Volladditivtechnik, indem man zur Aktivierung Edelmetallaktivatoren und als Basismaterial Folien oder biegsame Platten verwendet, deren Oberfläche a) ein flächenbezogenes spezifisches Gesamtporenvolumen von 0.015-0,045 $dm^3/m^2$, b) einen mittleren Porendurchmesser von 0.05-5,0 µm und c) eine mittlere Porentiefe von 0,05-4,0 µm aufweist.

EP 0 259 754 A2

## Flexible Schaltungen

Gegenstand der Erfindung sind sogenannte "flexible Schaltungen", worunter man gedruckte Schaltungen auf biegsamem Basismaterial versteht (vergl. z. B. "Handbuch der Leiterplattentechnik" von Günther Herrmann, Lenze-Verlag, 2. Auflage (1982), S.51).

Die Herstellung von flexiblen Schaltungen, beispielsweise Flachbandleitungen, Schaltungen in elektronisch arbeitenden Kameras, Kabelbäumen zum Verbinden von Bauelementen, Armaturenbrettverdrahtungen in Automobilen, Flachleitungen und Kabelbäume in der Datenverarbeitung und im Flugzeug-und Raketenbau, aus Kupfer-kaschierten Folien nach Subtraktionstechniken ist bekannt.

Die bekannten Subtraktions-Verfahren haben nicht nur den Nachteil der Unwirtschaftlichkeit, sondern sie führen auch beim Ätzprozeß zur Unterätzung der Leiterbahnen. Durch diesen Unterätzungseffekt ist es nicht möglich, mit Hilfe der Subtraktions-Verfahren Feinleiterbahnen mit einer Leiterbahnenbreite und einem Leiterbahnenabstand von weniger als 200 µm herzustellen.

Um die angegebenen Nachteile zu vermeiden, wurde bereits versucht, die sog. Semiadditiv-und Volladditiv-Verfahren zu entwickeln. Zur Durchführung dieser Verfahren ist das Aufbringen einer dünnen, gut haftenden, elektrisch leitfähigen Metallauflage von größter Wichtigkeit.

Es ist in diesem Zusammenhang bekannt, daß die Abscheidung von haftfesten Metallauflagen auf den üblichen starren Basismaterialien eine aufwendige Vorbehandlung erfordert. So müssen beispielsweise die Basisplatten aus glasmattenverstärken Epoxidharzen oder papierverstärkten Phenolharzen zur Herstellung von Leiterplatten zu-nächst mit einer Haftvermittlerschicht versehen und anschließend mit einer oxidierenden Flüssigkeit, vorzugsweise Chromschwefelsäure, behandelt werden, bevor die so präparierten Platten mit ionischen oder kolloidalen Edelmettalllösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es ist daher bereits vorgeschlagen worden, die nichtleitenden Oberflächen von Substraten, beispielsweise Basisträger von Leiterplatten, ohne oxidative Vorbehandlung mit einer Lösung oder einem Lack einer Edelmetallaminkomplexbildung bzw. des Palladiumchlorids für die anschließende chemische Metallisierung zu aktivieren (vgl. z.B. DE-A 1 696 603 und DE-A 2 116 389, entsprechend US-A 3 560 257 bzw. US-A 4 248 632).

Diese an sich materialschonenden Aktivierungsverfahren konnten sich jedoch bislang in der Praxis nicht durchsetzen, da sie verhältnismäßig große Edelmetallmengen benötigen und die in der Elektronikindustrie geforderten hohen Abzugsfestigkeiten der Metallauflagen nicht erreichen. Aus diesem Grunde wird zumindest in der erstgenannten Patentpublikation eine zusätzliche Oberflächenbehandlung mit Ätzmittel empfohlen (vgl. Spalte 6, Zeile 48).

Es wurde nun gefunden, daß man diese Nachteile vermeiden kann und auf einfache Weise, d.h. ohne Ätzung, mittels einer Semi-oder Volladditivtechnik unter Verwendung von üblichen Aktivatorsystemen zu hochwertigen flexiblen Schaltungen gelangt, wenn man als Basismaterial ein solches verwendet, dessen Oberfläche charakterisiert ist durch

a) ein flächenbezogenes spezifisches Gesamtporenvolumen von 0,015-0,045 $dm^3/m^2$

b) einen mittleren Porendurchmesser von 0,05-12,0 µm und

c) eine mittlere Porentiefe von 0,05-12,0 µm.

Das bevorzugte Porenvolumen liegt zwischen 0,020 und 0,040 $dm^3/m^2$, insbesondere zwischen 0,023 und 0,038 $dm^3/m^2$.

Bevorzugte Porendurchmesser sind 0,5-5 µm, insbesondere 1-2 µm.

Bevorzugte Porentiefen sind 0,1-4,0 µm, insbesondere 0,5-2,5 µm.

Das erfindungsgemäße Verfahren zur Herstellung von flexiblen Schaltungen ist dadurch gekennzeichnet, daß man das Basismaterial mit der oben spezifizierten Oberflächenbeschaffenheit mit einem organometallischen Aktivatorsystem der angegebenen Art behandelt, gegebenenfalls mit einem Reduktionsmittel sensibilisiert, die so erhaltenen Halbzeuge in einem naßchemischen Metallisierungsbad ganzflächig oder patiell metallisiert und anschließend die Leiterplatten nach den bekannten Prinzipien der Semi-oder Volladditiv-Technik fertigstellt.

In einer besonderen Ausführung des erfindungsgemäßen Verfahrens werden zur Erhöhung der Prozeßsicherheit die so behandelten Foliensubstrate bei einer Temperatur von 50°C bis zum Zersetzungsbereich vorzugsweise im Bereich der Erweichungstemperatur getempert.

Zur Erzeugung der erfindungsgemäßen Oberflächenbeschaffenheit sind sowohl physikalische Methoden (z.B. spezielle Sandstrahltechniken, Bürstmethoden oder Laserbestrahlung) als auch chemische Verfahren (z.B. Behandlung mit selektiv wirksamen Lösungsmitteln) geeignet. Eine andere Variante zur Erzeugung dieser Oberflächen besteht darin, daß metallkaschierte Basis auf chemischem Wege in einem Redoxbad (siehe beispielsweise G. Herrmann et al. "Leiterplatten, Herstellung und Verarbeitung", S. 103 bis 108, G. Leuze Verlag, Saulgau/Württ. 1978) oder auf elektrisch-galvanischem Wege von ihrer Kaschierung befreit werden, worauf sich automatisch die erfindungsgemäße Oberflächenstruktur einstellt.

Bei den verwendbaren Basismaterialien handelt es sich um Folien oder biegsame Platten aus verschiedenen Polymeren, beispielsweise aus Polytetrafluorethylen (Teflon), Polyvinylidenfluorid und Polyvinylfluorid (Tedlar) bzw, aus aromatischen und/oder aliphatischen Polyestern,Polyimiden, Polyamidimiden, Polycarbonaten, Polyamiden, Polysulfonen wie Udel, ein Polykondensat auf Basis von Bisphenol-A und 4,4'-Dichlordiphenylsulfon, aus Polyethersulfonen, die beispielsweise durch Polykondenstation des Diphenylethersulfonsäurechlorids herstellbar sind, Polyhydantoinen, Polybenzoxazindionen, Polyphenylensulfid und aus Polyphenylenoxiden wie Poly-2,6-dimethylphenylenoxid. Selbstverständlich können auch Pfropf-, Co- und Mischpolymerisate der o.a. Materialien zur Durchführung des erfindungsgemäßen Verfahrens eingesetzt werden. Im Prinzip sind alle Folienmaterialien verwendbar, die in den speziellen Anwendungsgebieten der Elektronik geeignet sind. Besonders bewährt haben sich bislang Polymere, die sich durch ihre Lötbadbeständigkeit auszeichnen. In diesem Zusammenhang seien aromatische Polyimid-, Polyamidimid-, Polyester-und Teflonfolien erwähnt.

Die Dicke der einzusetzenden Folien ist für das Wesen der Erfindung ohne Belang und kann von ca. 20 µm bis 250 µm betragen. Im Extremfall können auch Substrate eingesetzt werden, die dünner oder dicker sind als der angegebene Bereich.

Selbstverständlich können auch verschiedene Folienmaterialien in verschiedener Weise miteinander kombiniert werden. Beispielsweise können Polyimidfolien einseitig oder beidseitig eine Teflonschicht enthalten. Voraussetzung ist lediglich, daß diese aufgebrachte Schicht haftfest genug mit der Trägerfolie verbunden ist und daß sie in der Lage ist, die notwendige Rauhigkeit, wie immer auch diese aufgebracht worden ist, aufzunehmen.

Die Folienmaterialien können mit Verstärkungsmaterialien, wie mit Glas-, Mineral-, Kohle-und Aramid-Fasern bzw. -Matten und deren Gemische untereinander verstärkt werden. Ebenso können aus den verschiedensten Gründen Mineralfüllstoffe in den Folien eingearbeitet sein.

Besonders bevorzugtes Basismaterial besteht aus aromatischen Polyestern (z. B. Polyethylenterephthalat und Polybutylenterephthalat) sowie aus Polyimiden, wie sie z. B. in DE-A 1 202 981 (entspricht US 32 87 311) beschrieben sind und die vorzugsweise folgender Formel entsprechen:

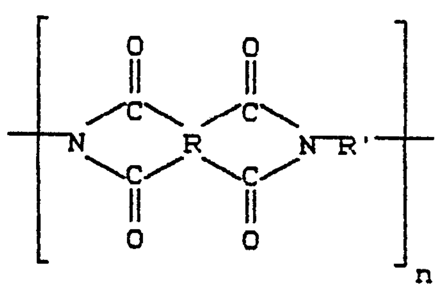

worin
R = vierwertiger aromatischer Rest, z. B.

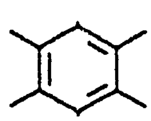

und
R' = Arylenrest, z. B.

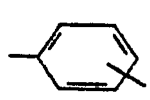 , 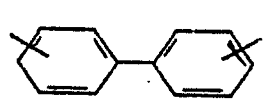 , 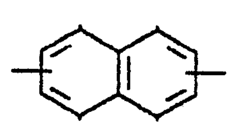 ,

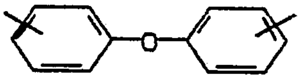 , 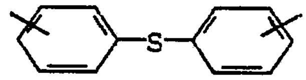 ,

oder 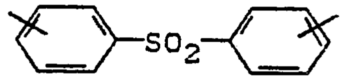 .

Zur Erzeugung der charakteristischen Oberfläche auf den Basismaterialien gemäß bevorzugten Verfahren werden die flexiblen Träger ein-oder beidseitig mit Metallfolien kaschiert, die anschließend abgelöst werden.

Zur Ablösung der Metallkaschierung sind wohl saure als auch neutrale und alkalische Redoxbäder geeignet. Beispeilsweise seien salz-oder schwefelsäurehaltige Redoxsysteme auf Basis von $H_2O_2$, $ClO_3^-$ und $Fe^{3+}$ sowie ammonialkalische natriumchlorit-und ammoniumpersulfathaltige Redoxsysteme erwähnt. Auch andere Redoxsysteme, die eine Abätzung der Metallauflage bewirken, können zur Durchführung des Verfahrens eingesetzt werden, vorausgesetzt, daß die Kunststoffoberfläche vom eingesetzten Redoxbad nicht angegriffen wird. Aus diesem Grunde sollen die üblichen aggressiven Kunststoffbeizbäder auf der Basis von Chromschwefelsäure möglichst vermieden werden, zumal diese auch die physikalischen Eigenschaften des Trägermaterials beeinträchtigen.

Optimale Oberflächenstrukturen werden erzielt, wenn man von einem Plattenmaterial ausgeht, das mit galvanisch erzeugten Metallfolien kaschiert worden ist.

Solche Metallfolien weisen nämlich eine besondere Porosität auf, die beim Kaschieren auf den polymeren Trägerwerkstoff für die Erzeugung der speziellen Oberflächenbeschaffenheit der Basismaterialien maßgeblich verantwortlich ist.

Die Bildung der Rauhigkeit auf der Folienoberfläche kann dadurch gefördert werden, daß man den Galvanisierungsbädern Komplexverbindungen auf der Basis von Antimon, Cadmium, Eisen, Selen und Tellur zusetzt oder nachträglich die Elektrolytfolie auf chemischem oder mechanischem Wege aufrauht.

Die Herstellung von solchen durch eine poröse Oberflächengestalt (Topografie) charakteriserten Metall-(vorzugsweise Kupfer-)-folien ist vielfach in der Literatur beschrieben worden. In diesem Zusammenhang seien erwähnt: "Metalloberfläche" Band 31 (12), 563 (1977), Band 38 (10), 439 ff (1984) und Band 38 (3), 103 ff (1984) sowie folgende Patentliteratur DE-A 2 235 522, DE-A 2 249 796, DE-A 2 500 160, DE-B 1 496 748, US 3 220 897, US 3 328 275, US 3 580 010 und US 3 227 636. Gemäß Verfahren der letztgenannten US-Patentschrift erhält man poröse Metall(Kupfer)-Folien, deren poröse Seite eine besonders wirksame Metall/Metalloxid-Struktur aufweist.

Geeignete Metallfolien leiten sich grundsätzlich von allen gängigen galvanisch abscheidbaren Metallen ab, wie Co, Ni, Pt, Pd, Ag, Al und vor allem Au und insbesondere Cu sowie deren Mischungen (vgl. z.B. "Plating", 52, 228-232 (1965)).

Nach dem Abbeizen der Metallkaschierung erhält man auf dem polymeren Trägerwerkstoff eine Oberflächenstruktur, die in ihren Dimensionen der des erfindungsgemäß zu verwendenden Basismaterials entspricht.

Zur Erzeugung der erfindungsgemäßen Oberflächen durch Sandstrahlen soll das Pulvermaterial eine mittlere Körnung von 0,1-10 µm, vorzugsweise 5-7 µm aufweisen. Pulvermaterialien auf Basis von Quarz, Korrund und Diamant sind zur Durchführung des Verfahrens gut geeignet, Um einen chemischen Abbau des polymeren Basismaterials zu vermeiden, kann selbstverständlich das Sandstrahlen unter Inertgasatmosphäre vorgenommen werden.

Vorzugsweise kann die zur Durchführung des erfindungsgemäßen Verfahrens geeignete poröse Oberflächenstruktur nach den bekannten Membranherstellungsmethoden erzielt werden (vgl. beispielsweise DE-A 24 31 071, US 4 286 015, DE-A 32 05 289 und GB 2 030 843). Hierbei wird bekannterweise das polymere Basismaterial mit einer Lösung aus Präpolymeren oder Polymeren, welches bezüglich ihrer

chemischen Beschaffenheit mit dem Basismaterial identisch ist und in Lösungsmittelgemischen unterschiedlicher Flüchtigkeit, die gegebenenfalls mit Quellmitteln und Porenbildnern enthalten, benetzt. Das leicht flüchtige Lösungsmittel wird teilweise verdampft, und anschließend wird das Koagulierungs-bzw. Fällungsmittel beispielsweise unter Vakuum der Polymermatrix entzogen.

Das "flächenbezogene spezifische Gesamtporenvolumen" ist das Produkt aus dem spexifischen Gesamtporenvolumen ($cm^3/g$) und der flächenbezogenen Masse ($g/m^2$) der Basismaterialien, d.h.
$[cm^3/g] \bullet [g/m^2] = [cm^3/m^2]$ bzw. $[10^{-3} \bullet dm^3/m^2]$

Die Definition des spezifischen Gesamtporenvolumens von Feststoffoberflächen findet man in Angew. Chem. 84, S. 331-336 (1972).

Unter "mittlerer Porentiefe" und "mittlerem Porendurchmesser" sind die Mittelwerte (unter Berücksichtigung der Gauß'chen Normalverteilung) der mit dem Rasterelektronenmikroskop ermittelten Porenabmessungen zu verstehen.

Als Aktivatoren kommen sowohl organische als auch anorganische Typen in Betracht. Bei den erfindungsgemäß zu verwendenden organischen Aktivatoren handelt es sich um an sich bekannte Edelmetallverbindungen, beispielsweise um Pd-un Pt-Komplexe von Dienen, polymeren Komplexbildnern und $\alpha,\beta$-ungesättigten Ketonen, wie sie z.B. in DE-A 30 25 307, 31 50 985 und 33 24 767 beschrieben sind.

Bevorzugt sind organometallische Verbindungen, vorzugsweise Ω-Komplexverbindungen, die außer der zur Metallbindung erforderlichen Gruppe wenigstens eine weitere funktionelle Gruppe aufweisen. Solche Verbindungen sind bekannt und in DE-A 3 148 280 beschrieben.

Mit der weiteren funktionellen Gruppe wird eine sehr gute Haftfestigkeit auf der Substratoberfläche erreicht, wobei diese Haftfestigkeit auf eine chemische Reaktion mit der Substratoberfläche oder auf eine Adsorption zurückgehen kann.

Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid-und Carbonimidgruppen, Aldehyd-und Ketongruppen, Ethergruppen, Sulfonamidgruppen, Sulfonsäuregruppen, un Sulfonatgruppen, Sulfonsäurehalogenidgruppen, Sulfonsäureestergruppen, halogenhaltige heterocyclische Reste, wie Chlorthiazinyl-, -pyrazinyl-, -pyrimidinyl-oder -chinoxalinylgruppen, aktivierte Deoppelbindungen, wie bei Vinylsulfonsäure-oder Acrylsäurederivaten, Aminogruppen, Hydroxylgruppen, Isocyanatgruppen, Olefingruppen und Acetylengruppen sowie Mercaptogruppen.

In einer weiteren Ausführungsform werden solche Edelmetallkomplexverbindungen angewendet, in denen die Liganden und die zu komplexierenden Ionen bzw. Moleküle in einer "Gast/Wirt"-Wechselbeziehung stehen.

Als selektive Komplexliganden kommen cyclische oder acyclische Verbindungen in Frage, die wegen ihrer chemischen und/oder physikalischen Beschaffenheit ein Wirtsmolekül sind oder in Gegenwart von zu komplexierenden ionogenen oder neutralen Verbindungen die zur Komplex-bzw. Adduktbildung erforderliche Form annehmen, wobie die polaren Bereiche in Gegenwart des zu komplexierenden Mediums zu diesem hinausgerichtet werden.

In der Literatur sind zahlreiche selektive Wirtsmoleküle, die mit den Alkali-oder Erdalkalikationen wie $Li^+$, $Na^+$, $K^+$, $Ca^{2+}$ oder $NH_4^+$ [vgl. E. Weber, "Kontakte" (Darmstadt) 1, (1981) und J. G. Schindler, "Bioelektrochemische Membranelektroden" S. 77-104, Walter de Gruyter Verlag, Berlin/New York (1983)] oder mit Schwermetallionen wie $Co^{2+}$. $Ni^{2+}$, $Fe^{3+}$, $Cd^{2+}$ und $Ag^+$ sowie mit Anionen wie $Cl^-$ und $SO_4^{2-}$ [vgl. vorstehend zitierte Arbeit von J.G. Schindler, S. 104-112] sowie mit den neutralen Liganden bzw. Verbindungen einen selektiven Gast-Wirtskomplex bilden können, beschrieben worden. Zur Durchführung der Aktivierung eignen sich alle Wirtskomplexliganden, die in ihrer Kette Heteroatome (O, N und S) enthalten. Gut geeignet sind Kronenether, Cryptanden und Podanden oder deren Derivate sowie cyclische Peptide; weiterhin tetrahydrofuranhaltige, esterverknüpfte Makrolide und analoge Verbindungen auf der Basis von Heteroatomen wie S und N, die beispielsweise in biologischen Systemen als Transportregulatoren bekannt sind.

Eine Definition der Begriffe "Kronenether", "Cryptande" und "Podanden" kann den Übersichtsarbeiten F. Vögtle, "Kontakte" (Darmstadt) (1977) und (1978), E. Weber, "Kontakte" (Darmstadt) (1984) sowie Vögtle "Chemikerzeitung" 97 , 600-610 (1973) entnommen werden.

Besonders bevorzugt werden substituierte bzw. unsubstituierte Wirtsliganden auf der Basis von cyclischen oder acyclischen Kronenethern, die in ihrem Ringsystem noch zusätzlich Heteroatome wie N und S enthalten können, eingesetzt. Solche Verbindungen sind in DE-A 2 842 862 bzw. EP-A 10 615 beschrieben.

Eine andere Variante der Durchführung des Aktivierungsverfahrens besteht darin, daß man die erwähnten Wirtsmoleküle in polymeren oder oligomeren Verbindungen kovalent einbaut und sie dann mit gewünschten Aktivierungsmedien komplexiert. Solche oligomere oder polymere Systeme sind bekannt und werden beispielsweise in "Novel Polyurethanes with Macroheterocyclic (Crown-Ether) Structures in the Polymer Backbone", J.E. Herweh, J. of Polymer Science: Polymer Chemistry Edition, Vol. 21, 3101 (1983) beschrieben.

Der anorganische Teile der Wirt/Gast-Molekeln wird vorzugsweise aus Verbindungen der Formeln $H_2PdCl_4$, $Na_2(PdCl_2Br_2)$, $Na_2PdCl_4$, Ca $PdCl_4$, $Na_4(PtCl_6)$, $AgNO_3$, $HAuCl_4$, $CuCl_2$ und CuCl gebildet. Bevorzugt sind die Pd-Verbindungen.

Bei den anorganischen Aktivatoren handelt es sich vor allem um kolliodale Systeme von metallischem Pd, Pt, Au und Ag, die gegebenenfalls darüber hinaus hydrolysierbare Verbindungen von Elementen der 3. und 4. Haupt-und Nebengruppen des Periodensystems (z.B. Si, Ti, Ta, Zn, Sn, Zr und Al) enthalten können.

Solche Aktivierungssysteme sind z.T. im Fachhandel erhältlich und im übrigen vielfach in der Literatur beschrieben worden (vgl. z.B. "Kunststoffgalvanisierung" von R. Weines, Eugen Lenze Verlag, Saulgau/Württemberg (1979), Seiten 180-209).

Bevorzugt sind Pd-und Pd/Sn-Systeme.

Die Aktivatoren können in Konzentrationsbereichen von 0,001 g/l (bezogen auf das Edelmetall) bis hin zur jeweiligen Löslichkeitsgrenze eingesetzt werden. Vorzugsweise arbeitet man mit 0,1 bis 3,0 g/l dieser Substanzen.

Dank ihrer hohen Lagerungsstabilität (keine Eintrübung der Lösungen - z.T. nach wochenlanger Lagerung) und ihrer starken Sorption im ultravioletten und/oder sichtbaren Spektralbereich, eignen sie sich hervorragend für die kontinuierliche Konzentrationsüberwachung mit einem Fotometer.

Im übrigen können die Sorptionseigenschaften der erfindungsgemäß zu verwendenden Komplexverbindungen durch Einführung spezieller Substituenten (insbesondere $-NO_2$, $-NR_3$, $-SO_3H$ und -CN) noch erhöht werden.

Zur Erhöhung der Abzugsfestigkeit der Aktivator-bzw. Metallauflage können die besagten Wirtsmoleküle zusätzlich mit einer weiteren funktionellen Gruppe versehen werden.

Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid-und Carbonimidgruppen, Aldehyd-und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige, heterocyclische Reste, wie Chlortriazinyl-, pyrazinyl-, pyrimidinyl-oder -chinoxalinylgruppen, aktivierte Doppelbindungen, wie bei Vinylsulfonsäure-oder Acrylsäurederivaten, Aminogruppen, Hydroxylgruppen, Iso cyanatgruppen, Olefingruppen und Acetylengruppen sowie Mercapto-oder Alkenylreste ab $C_8$, insbesondere Olein-, Linolein-, Stearin-oder Palmitingruppen.

Wenn keine Verankerung durch eine chemische Reaktion stattfindet, kann die Haftfestigkeit auch durch Adsorption der organometallischen Aktivatoren an der Substratoberfläche bewirkt werden, wobei als Ursachen für die Sorption z.B. Wasserstoffbrückenbindungen oder van der Waalssche-Kräfte in Frage kommen.

Es ist zweckmäßig, die die Adsorption hervorrufenden funktionellen Gruppen auf das jeweilige Substrat abzustimmen. So verbessern z.B. langkettige Alkyl-oder Alkenyl-Gruppen im Aktivatormolekül die Haftfestigkeit auf Substraten aus Polyethylen oder Polypropylen. Zur Metallisierung von Gegenständen auf Polyamid- oder Polyesterbasis sind dagegen Aktivatoren mit beispielsweise zusätzlichen Carbonyl-oder Sulfongruppen besonders günstig.

Besonders geeignet für eine Verankerung des Aktivators an der Substratoberfläche durch Adsorption sind funktionelle Gruppen wie Carbonsäuregruppen, Carbonsäureanhydridgruppen.

Bei der praktischen Durchführung der Aktivierung geht man im allgemeinen so vor, daß man die zu metallisierenden Basisträger mit einer Lösung des selektiven Metallkomplexes in einem geeigneten organischen Lösungsmittel benetzt, das Lösungsmittel entfernt und gegebenenfalls mit einem geeigneten Reduktionsmittel sensibilisiert. Danach kann der so vorbehandelte Träger in einem üblichen Metallisierungsbad metallisiert werden.

Als Reduktionsmittel für die Sensibilisierung eignen sich Aminoborane, Alkalihypophosphite, Alkylborhydride, Hydrazinhydrat und Formalin. Das Benetzen der Substrate kann durch Besprühen, Bedrucken, Tränken oder Imprägnieren erfolgen.

Um die Haftung der Metallauflage an der Trägeroberfläche zu erhöhen, werden solche Lösungsmittel oder Lösungsmittelgemische, die zu einer geringen Anlösung oder Anquellung der zu metallisierenden Kunststoffoberfläche führen, besonders bevorzugt eingesetzt.

Zur Durchführung dieses Verfahrens sind aprotische Lösemittel wie 1,1,1,-Trichlorethan, Methylenchlorid, Trichlormethan, Perchlorethylen, Toluol besonders gut geeignet. Erfindungsgemäße Aktivierungssysteme, die noch zusätzlich hydrolysierbare metallorganische Verbindungen des Titans, Aluminiums, Zirkons, Siliziums oder Tantals in Mengen von 0,1-20, vorzugsweise 0,1-3, besonders bevorzugt 0,1-2 g/l enthalten, werden bevorzugt eingesetzt.

Die Entfernung der Lösungsmittel von den benetzten Trägen erfolgt einfach durch Verdampfen oder bei höher siedenden Verbindungen durch Extraktion.

Nach einer bevorzugten Verfahrensvariante werden die organischen Aktivierungsbäder mit einem Fotometer als Detektor überwacht.

Eine ganz besonders bevorzugte Ausführungsform der Aktivierung besteht darin, daß die Reduktion im Metallisierungsbad gleich mit dem Reduktionsmittel der stromlosen Metallisierung durchgeführt wird.

Diese Ausführungsform ist ganz besonders für aminboranhaltige Nickelbäder oder formalinhaltige Kupferbäder geeignet.

Als in dem erfindungsgemäßen Verfahren einsetzbare Metallisierungsbäder kommen handelsübliche heiße und kalte Bäder von Nickelsalzen, Cobaltsalzen, Kupfersalzen, Gold-und Silbersalzen oder deren Gemische in Betracht, wobei die Cu-Bäder ganz besonders zu bevorzugen sind.

Für eine gegebenenfalls durchzuführende galvanische Verstärkung kommen folgende Metalle in Frage: Ni, Co, Cu, Ag, Al, Cr und Au. Bevorzugt sind Cu, Au und Ni, ganz besonders bevorzugt ist Cu.

Um gegebenenfalls die Haftung der auf der erfindungsgemäßen Kunststoffoberfläche abgeschiedenen Metallauflage zu erhöhen bzw. um eine 100 %ige Prozeßsicherheit zu gewährleisten, kann eine Temperung vorgenommen werden.

Die Temperungstemperatur kann im breiten Bereich von 50°C bis zum jeweiligen Zersetzungsbereich des polymeren Basimaterials variiert werden, wobei für Polyimidfolien beispielsweise die Temperaturen von 125°C-250°C, insbesondere von 140-180°C zu bevorzugen sind. Für Polyesterfolien sind dabei z.B. Temperturen von 125-180°C, insbesondere von 140-170°C, geeignet. Die Temperungszeiten können zwischen 5 Minuten bis 10 Stunden variiert werden, wobei die Zeiten 10 bis 60 Minuten zu bevorzugen sind. Um einen Abbau des Basismaterials zu vermeiden, kann die Temperung unter Inertgas vorgenommen werden.

Selbstverständlich kann die Temperung auch nach der galvanischen oder chemischen Verstärkung der Metallauflage auf die gewüschte Schichtdicke vorgenommen werden.

Die aus diesen Folien durch Aktivieren erhältlichen Vorprodukte sowie die daraus hergestellten flexiblen Schaltungen weisen überraschenderweise folgende gute Eigenschaften auf:

1. Sie sind an der Luft gegenüber Feuchtigkeit, Witterungs-und Wärmeeinflüsse stabil.

2. Ihre Aktivatorauflage ist nicht während des Aufbringens bzw. des Entwickelns von Fotoresistauflagen von der Oberfläche entfernbar. Sie läßt sich problemlos mit Hilfe von bekannten Oberflächenanalysemethoden, wie ESCA, nachweisen.

3. Die Abzugsfestigkeiten der Metallauflagen nach DIN 53 494 beträgt mindestens 15, vorzugsweise jedoch 30-35 N/25 mm und mehr.

4. Bei der Sensibilisierung bzw. Metallisierung tritt keine Vergiftung der Metallisierungs-oder Sensibilisierungsbäder ein.

Das Verfahren ist besonders gut geeignet für die Herstellung von flexiblen Schaltungen mit Feinstleiterbahnen.

Mit Hilfe dieses Verfahrens können auch dünne (<10 µm) und besonders dünne Metallschichten (0,3 bis 5 µm) auf Folien erzeugt werden, die bei geeigneter Strukturierung in verschiedenen Anwendungsgebieten Einsatz finden können.

Diese dünnen Schichten können je nach der gewünschten Dicke durch chemische oder durch chemische und galvanische Metallabscheidung hergestellt werden.

Nach dem erfindungsgemäßen Verfahren lassen sich vorteilhaft herstellen:

Folientastaturen, Schaltmatten, Sensoren, Digitiser, Multilayer, Abschirmungen usw. Derartig hergestellte flexible Schaltungen lassen sich auch durch Hinterspritzen in Spritzgußmaschinen zur Herstellung von 3-dimensionalen Schaltungen benutzen.

Beispiel 1

Eine handelsübliche einseitig kupferbeschichtete Polyimidfolie, z.B. der Fa. Krempel, Stuttgart (Germany), wird durch Abätzen in einer alkalischen 15,7 %igen Natriumchloritlösung (pH ~ 12) von der Cu-Auflage befreit, mit $H_2O$ und dann mit Methanol gewaschen und getrocknet. Man erhält eine an der Oberfläche poröse Folie mit einem flächenbezogenen spezifischen Gesamtporenvolumen von 0,025 $dm^3/m^2$ und einem mittleren Porendurchmesser von 2,0 µm bzw. einer mittleren Porentiefe von 2,5 µm. Diese Folie wird anschließend fünf Minuten in einer Lösung bestehend aus 0,5 g n-3-Hepten-2-on-palladiumchlorid und 1.000 ml 1,1,1-Trichlorethan aktiviert, getrocknet und dann einer Lösung bestehend aus 750 ml $H_2O_{dest.}$, 7,5 g Dimethylaminboran und 1,75 g NaOH (fest) sensibilisiert, in einem handelsüblichen Verkupferungsbad verkupfert, mit Wasser gewaschen und im Trockenschrank eine Stunde lang bei 170°C getempert. Die so mit einer gut haftenden, elektrischleitenden Metallauflage versehene Probe wird mit Hilfe des Siebdruckverfahrens mit einem Lack auf Basis von Polybutadien beschichtet, wobei freie rasterförmige Bahnen von etwa 200 µm ausgespart bleiben, und dann die freie Metalloberfläche mit galvanischem Kupfer auf ca. 35 µm verstärkt. Nun wird die Folie in Methylethylketon von der Maske befreit und die darunter liegende auf chemischen Wege abgeschiedene Kupferauflage in einer schwefelsauren, $H_2O_2$ enthaltenden Lösung abgeätzt. Man erhält eine elektrische Schaltung mit ca. 200 µm breiten und ca. 32 µm starken Leiterbahnen. Die Metallauflage haftet auf der Substratoberfläche sehr gut und läßt sich nach herkömmlichen Methoden löten.

Beispiel 2

15g methanolische $K_2PtCl_6$-Lösung (Pt-Gehalt etwa 1,75 Gew.-%) werden mit 1 l einer Lösung von 5 ml HCl (37 %ig) und 2,5 g $SnCl_2$ in destilliertem Wasser bei 46°C versetzt. Man rührt dann 45 Minuten nach und erhält eine dunkel gefärbte homogene Aktivierungslösung. Mit dieser Lösung werden nach Beispiel 1 mit Poren versehene Polyimidfolien 5 Minuten lang behandelt. Eine so aktivierte Folie wird in einem Sensibilisierungsbad, welches pro Liter 20 ml $NH_2$-$NH_2$, 12 ml $NH_3$ (25 %ig) enthält, 7,5 Minuten sensibilisiert und dann in einem handelsüblichen Verkupferungsbad bei 80°C 45 Minuten metallisiert und anschließend bei 150°C 90 Minuten lang nachgetempert. Man bekommt eine mit einer gut haftenden, ~ 3 µm starken Cu-Auflage versehene Folie, die sich nach einer partiellen Maskierung mit einem handelsüblichen Fotolack, nach galvanischer Verstärkung der freien Bahnen und anschließender Befreiung der Folienoberfläche vom Fotolack und schließlich durch Abätzen der darunter befindlichen Cu-Auflage im Differenzätzprozeß zu einer lötbaren, flexiblen Schaltung verarbeiten läßt.

Die so hergestellten flexiblen Schaltungen lassen sich problemlos mit herkömmlichen Lötsystemen löten und bestehen den branchenüblichen Temperaturwechseltest.

Beispiel 3

Eine handelsübliche mit Kupfer kaschierte Polyesterfolie, z.B. der Fa. Krempel (Germany) wird in einer Redox-Lösung bestehend aus 50 ml HCl (37 %ig), 60 ml $H_2O_2$ und 500 ml $H_2O$ von der Cu-Auflage befreit. Man bekommt eine oberflächenporöse Folie mit einem flächenbezogenen spezifischen Gesamtporenvolumen von 0,024 $dm^3/m^2$ und einem mittleren Porendurchmesser von 2,5 µm bzw. einer maximalen Porentiefe von 3,0 µm. Diese Folie wird in einer Lösung bestehend aus 200 ml Aceton, 800 ml $H_2O_{dest.}$ und 0,8 g Mesityloxidpalladiumchlorid im Verlaufe der 3 Minuten aktiviert. Danach wird die Platte 5 Minuten in einer Lösung von 5 g Dimethylaminboran in einem 1 l $H_2O$/Methanol-Gemisch (50:50 Vol.-%) behandelt. Nach kurzem Spülen werden in einem chemischen Cu-Bad eine ca. 0,2 µm starke Cu-Auflage aufgetragen. Die chemisch verkupferte Folie wird, wie im Beispiel 4 angegeben, weiterverarbeitet. Man erhält eine flexible Schaltung mit einer sehr guten Metallhaftung.

Beispiel 4

Verfährt man wie im Beispiel 3 angegeben und erzeugt in üblicher Weise eine galvanisch leicht verstärkte Cu-Schicht (z.B. in einem Bereich zwischen 0,5 und 5 µm), so erhält man ein Halbzeug, das in verschiedenerlei Weise für die Sensortechnik eingesetzt werden kann.

## Ansprüche

1. Flexible Schaltungen bestehend im wesentlichen aus dem flexiblen Basismaterial und dem naßchemisch unter Verwendung von Aktivatorsystemen, nach den Prinzipien der Semi-oder Volladditivitechnik aufgebrachten Leiterbild, dadurch gekennzeichnet, daß die Oberfläche des Basismaterials charakterisiert ist durch
   a) ein flächenbezogenes spezifisches Gesamtporenvolumen von 0,015-0,045 $dm^3/m^2$
   b) einen mittleren Porendurchmesser von 0,05-12,0 $\mu m$ und
   c) eine mittlere Porentiefe von 0,05-12,0 $\mu m$.
2. Flexible Schaltungen gemäß Anspruch 1, dadurch gekennzeichnet, daß
   a) das Porenvolumen 0,20-0,40 $dm^3/m^2$,
   b) der Porendurchmesser 1-2 $\mu m$ und
   c) die Porentiefe 0,5-2,5 $\mu m$ betragen.
3. Flexible Schaltungen gemäß Anspruch 1, dadurch gekennzeichnet, daß als Aktivatoren organische Edelmetallverbindungen aus der Reihe Pt, Pd, Au, Ag und/oder Rh verwendet werden.
4. Flexible Schaltungen nach Anspruch 1, dadurch gekennzeichnet, daß man zur Aktivierung eine Gast/Wirt-Komplexverbindung von Edelmetallen verwendet.
5. Flexible Schaltungen nach Anspruch 1, dadurch gekennzeichnet, daß man zur Aktivierung organometallische Komplex-Verbindungen verwendet, die außer der zur Metallbindung erforderlichen Gruppe wenigstens eine weitere funktionelle Gruppe zur Verbesserung der Haftfestigkeit auf den Substratoberflächen aufweisen.
6. Verfahren zur Herstellung von flexiblen Schaltungen, dadurch gekennzeichnet, daß man Basismaterialien mit der in Anspruch 1 charakterisierten Oberflächenbeschaffenheit mit einem organometallischen Aktivatorsystem behandelt, gegebenenfalls sensibilisiert, die so erhaltenen Halbzeuge naßchemisch ganzflächig oder partiell metallisiert und die Leiterplatten in üblicher Weise fertigstellt.
7. Verfahren zur Herstellung von flexiblen Schaltungen, dadurch gekennzeichent, daß man Basismaterialien beidseitig mit einer Metallfolie kaschiert, die Kaschierung chemisch in einem Redoxbad oder elektrogalvanisch ablöst, die so vorbehandelten Basismaterialien mit einer organischen Verbindung eines Edelmetalls aktiviert, gegebenenfalls sensibilisiert und auf den so erhaltenen Halbzeugen durch Anwendung einer Semi-oder Volladditivtechnik die metallischen Leiterbilder aufbringt.
8. Verfahren nach Anspruch 7, dadurch gekennzeichnet, daß man als Metallfolie eine galvanisch hergestellte Kupfer-oder Aluminiumfolie verwendet.
9. Verfahren nach Anspruch 6 oder 7, dadurch gekennzeichnet, daß zu Verbesserung der Haftfestigkeit der Metallauflagen eine Temperung des metallisierten Basismaterials vorgenommen wird.
10. Verwendung der flexiblen Schaltungen gemäß Anspruch 1 bzw. erhalten gemäß Verfahren der Ansprüche 6 und 7 als Folientastaturen, Schaltmatten, Sensoren, Digitiser, Multilayer und Abschirmausgangsmaterialien.